# EUROPÄISCHE PATENTSCHRIFT

(11) **EP 1 836 123 B1**
(45) Veröffentlichungstag und Bekanntmachung des Hinweises auf die Patenterteilung: **25.06.2008**
(21) Anmeldenummer: 06700450.7
(22) Anmeldetag: 04.01.2006
(51) Int. Cl.: B81B 7/00

(54) **VERFAHREN ZUM ERZEUGEN EINES VORGEGEBENEN INNENDRUCKS IN EINEM HOHLRAUM EINES HALBLEITERBAUELEMENTS**
METHOD FOR GENERATION OF A GIVEN INTERNAL PRESSURE IN A CAVITY OF A SEMICONDUCTOR COMPONENT
PROCEDE POUR PRODUIRE UNE PRESSION INTERNE PREDETERMINEE DANS UNE CAVITE D'UN COMPOSANT A SEMI-CONDUCTEUR

(30) Priorität: 12.01.2005 DE 102005001449
(43) Veröffentlichungstag der Anmeldung: 26.09.2007
(73) Patentinhaber: Fraunhofer-Gesellschaft zur Förderung der angewandten Forschung e.V., 80686 München (DE)
(72) Erfinder: QUENZER, Hans, Joachim, 25524 Itzehoe (DE); MERZ, Peter, 25557 Beldorf (DE); OLDSEN, Martin, 22761 Hamburg (DE); REINERT, Wolfgang, 24536 Neumünster (DE)
(74) Vertreter: Schenk, Markus
(86) Internationale Anmeldenummer: PCT/EP2006/000040
(87) Internationale Veröffentlichungsnummer: WO 2006/074871

(56) Entgegenhaltungen:
- DE-A1- 3 743 080
- DE-A1- 19 961 578
- US-A1- 2004 077 117
- SHELBY J E: "Helium migration in glass-forming oxides" JOURNAL OF APPLIED PHYSICS USA, Bd. 43, Nr. 7, Juli 1972 (1972-07), Seiten 3068-3072, XP002373522 ISSN: 0021-8979

## Beschreibung

Die vorliegende Erfindung bezieht sich auf ein Verfahren zum Erzeugen eines vorgegebenen Innendrucks in einem Hohlraum eines Halbleiterbauelements.

Mikroresonatoren, Vibrationssensoren, Vibrationsgyroskope und mikroelektromechanische Systeme, beispielsweise aus Silizium, können mit Hilfe von Verfahren abgeleitet aus der Mikroelektronik kostengünstig in großen Stückzahlen hergestellt werden. Aufgrund der kleinen Dimensionen der Bauteile müssen diese Schwingungselemente in einem Vakuum betrieben werden. Im Falle der Resonatoren liegt der Druck in dem Hohlraum typischerweise im Bereich von ca. 1*10⁻⁴ mbar bis zu ca. 1 mbar.

Da eine hermetisch dichte Gehäusetechnik auf Basis einzelner Bauelemente vergleichsweise teuer ist und zudem einen Schutz der Bauelemente bereits während des Sägens der Siliziumwafer erfordert, ist das Verkapseln der Resonatoren bereits auf Waferebene weit verbreitet. Dabei wird auf dem Wafer, der das Bauelement beinhaltet, ein zweiter Siliziumwafer, versehen mit entsprechenden Vertiefungen, aufgesetzt und schließlich unter Vakuum hermetisch dicht mit dem ersten Wafer verbunden. Verschiedene Verfahren kommen dabei als Verbindungstechnik in Betracht: zum einen können die Wafer mit einem Glas- oder metallischen Lot gefügt werden, zum anderen können die Wafer auch mittels anodischem Bonden versiegelt werden.

Vor dem eigentlichen Bonden werden die Wafer justiert und in einer Klemmvorrichtung fixiert. Dabei gewährleisten dünne Abstandshalter zwischen den Wafern, dass die Wafer nicht direkt in Kontakt kommen. Nach Einbringen der gesamten Klemmanordnung werden der Raum um und zwischen den Wafern evakuiert, der obere und untere Wafer durch Heizplatten erhitzt, anschließend die Waferoberflächen in Kontakt gebracht (nach Entfernen der Abstandshalter) und schließlich die eigentliche Bondung durchgeführt.

Die Dicke der verwendeten Abstandshalter bewegt sich im Bereich zwischen 50 - 500 µm. Damit liegt die Distanz zwischen den Wafern aber bereits in einer Dimension, die sich in etwa mit dem der mittleren freien Weglänge der Gasmoleküle bei Drücken von unter 1 mbar deckt, so dass Diffusionsprozesse primär das Verhalten der Gase im Zwischenraum der Wafer bestimmen, womit es deutlich schwieriger und zeitraubender wird, die Gase zu entfernen.

Bedingt durch den geringen Abstand zwischen den Wafern und dem vergleichsweise ungünstigen Verhältnis zwischen Innenvolumen und innerer Oberfläche in den Hohlräumen in den Halbleiterbauelementen, wie zum Beispiel Sensoren, ist es erfahrungsgemäß schwierig, die Wafer so zu fügen, dass ein Innendruck von deutlich unter 1 mbar erreicht werden kann.

Erschwerend kommt hinzu, dass aufgrund des vergleichsweise langsamen Ausgasens der Oberflächen zwischen den Wafern der eingestellte Druck innerhalb verschiedener Hohlräume der auf dem Wafer angeordneten Halbleiterbauelemente nicht konstant ist. Während die Hohlräume in den Halbleiterbauelementen am Waferrand häufig Drücke von deutlich unterhalb 1 mbar erreichen, sind die erreichten Vakua in den verschiedenen Hohlräumen, die sich weiter innerhalb des Wafers befinden, meist deutlich schlechter. Es stellt sich somit während des Evakuierens der Wafer vor dem Bonden eine Druckverteilung ein, deren Minima am Waferrand und deren Maxima in der Wafermitte liegen. Das Einbringen von Durchbrüchen im oberen oder unteren Wafer bringt keinen Vorteil, da die Wafer während des Bondens in Kontakt mit der oberen bzw. unteren Heizplatte sind.

Letztlich können niedrige Innendrücke in den Hohlräumen in einer für eine Massenfertigung geeigneten Prozessdauer und Uniformität über dem Wafer nur mit Hilfe eines zusätzlichen Gettermaterials innerhalb der Sensorkavität erreicht werden. Zwar braucht das Gettermaterial eine zusätzliche Aktivierung entweder während oder nach dem eigentlichen Bondvorgang, die die Zeitdauer des Bondprozesses verlängert, anderseits lassen sich nur durch die Verwendung eines Getters Vakua im Bereich von 10⁻⁴ - 1 mbar sicherstellen. Aufgrund der üblicherweise angestrebten Lebensdauer von mindestens 10 bis 15 Jahren ist die Verwendung eines Getters ebenfalls dringend geboten.

Allerdings sind mit der Sicherstellung des Vakuums nur vordergründig alle Probleme der Vakuum-Verkapselung der Hohlräume in den Halbleiterbauelementen, wie beispielsweise Sensoren gelöst. Tatsächlich benötigen häufig Halbleiterbauelemente mit Hohlräumen, wie z.B. resonant betriebene Sensoren, nicht nur einfach ein Vakuum unterhalb eines kritischen Druckwerts in dem Hohlraum, vielmehr wird ein Vakuum innerhalb eines bestimmten Druckbereichs benötigt, d.h. es müssen gezielt Gase, in der Regel Edelgase, die nicht vom Gettermaterial absorbiert werden, zugesetzt werden, um den Druck in dem Hohlraum innerhalb des gewünschten Druckbereichs zu bringen bzw. zu halten.

Bedingt durch den geringen Abstand zwischen den Wafern und damit dem Vorliegen eines durch ein Diffusionsverhalten gekennzeichneten Druckregimes gelingt ein Einbringen der Gase allerdings genauso schwierig bzw. unvollkommen wie die Versuche zuvor, das Vakuum alleine durch Evakuieren zu erreichen. Insbesondere die erreichbaren Uniformitäten der Verteilung des Innendrucks in dem Hohlraum der Sensoren bzw. Halbleiterbauelemente über den Wafer erweisen sich für eine erforderliche Funktionalität der Bauelemente als nicht ausreichend.

Eine Verbesserung kann durch den Einsatz eines Gasgemisches bestehend aus Stickstoff und einigen Anteilen eines Edelgases, wie z.B. Argon, erreicht werden. Damit werden die Wafer unmittelbar vor dem Bonden einem Druck von ca. 5 mbar ausgesetzt. Die Verwendung des erhöhten Drucks erlaubt einen schnelleren Druckausgleich auch zwischen den Wafern, da in diesem Druckregime das Verhalten der Gase nicht mehr zur Gänze durch Diffusionsvorgänge bestimmt ist. Nach dem Donden absorbiert der Getter den verbliebenen Stickstoff, während das Edelgas in dem Hohlraum bzw. der Sensorkavität verbleibt.

Die mit obigen Verfahren zum Erzeugen eines Innendrucks in einem Hohlraum erreichten Ergebnisse bringen zwar eine Verbesserung der Druckverteilung bzw. Innendruckverteilung zwischen einer Anzahl von Hableiterbauelementen durch das Einstellen eines vorbestimmten Drucks in der Umgebung vor dem Bonden der Wafer ein, aber dennoch sind die erreichten Ergebnisse für eine korrekte Funktionalität der so realisierten Bauelemente nicht ausreichend.

Die DE 19961578 A1 beschreibt Sensoren mit einer mikromechanischen Struktur und Verfahren zu deren Herstellung. Unter anderem bezieht sich das Dokument auf Drucksensoren. Die vorgestellten Verfahren zur Herstellung basieren wesentlich darauf, dass der Sensorraum, in dem die mikromechanischen Strukturen untergebracht sind, über Trenchgräben in einer oberhalb des eigentlichen Hohlraumes befindlichen Polysiliziumschicht zunächst mit einem hochporösen Oxid gefüllt wird, das sich mit einer extrem hohen Ätzrate durch flusssäurehaltige Medien wieder entfernen lässt. Das hochporöse Oxid wird entfernt, nachdem dasselbe bzw. der Sensorraum mittels einer Abscheideschicht abgedeckt worden ist, wozu die Abscheideschicht durchlässig, permeabel für das verwendete Ätzmedium zum Ätzen des porösen Oxids als auch für die während der Reaktion entstehenden Produkte ist. Insbesondere könne die Abscheideschicht kleine ätzöffnungen aufweisen oder aus einem permeablen Polysilizium oder einem nachträglich durch Porosifizierung permeabel gemachten Polysilizium bestehen. Nach dem Entfernen des porösen Oxids durch die Abscheideschicht hindurch, wird eine hermetische Abdichtung durch anschließendes Aufbringen einer Abdichtungsschicht erzielt.

Der vorliegenden Erfindung liegt die Aufgabe zugrunde, ein Verfahren zum Erzeugen eines vorgegebenen Innendrucks in einem Hohlraum eines Halbleiterbauelements zu schaffen, das unaufwendiger und/oder effizienter ist, und insbesondere eine homogenere Innendruckverteilung in einer Menge von Halbleiterbauelementen ermöglicht.

Diese Aufgabe wird durch ein Verfahren gemäß Anspruch 1 gelöst.

Der vorliegenden Erfindung liegt die Erkenntnis zugrunde, dass bei einem Halbleiterbauelement mit einem Halbleiteroxidbereich, wie z.B. aus SiO₂, zwischen einem Hohlraum und einer Außenoberfläche des Halbleiterbauelements der Halbleiteroxidbereich als eine Art Ventil zum Durchlassen eines bestimmten Edelgases verwendet werden kann, um einen vorgegeben Innendruck zu erzielen. Insbesondere besteht eine Erkenntnis der vorliegenden Erfindung darin, dass sich ein vorbestimmter Innendruck dadurch erzielen lässt, dass das Bauelement einer Edelgasatmosphäre bei einer ersten Temperatur ausgesetzt wird, bei der der Halbleiteroxidbereich für das Edelgas durchlässig bzw. permeabel ist bzw. das Ventil offen ist, und dann auf eine andere Temperatur umgestellt wird, bei der der Halbleiteroxidbereich für das Edelgas weniger oder undurchlässig bzw. weniger oder nicht permeabel ist bzw. das Ventil geschlossen ist, und die beispielsweise in einem Sollverendungstemperaturbereich des Halbleiterbauelementes liegt, also der zugelassenen Betriebstemperatur. Durch ein geeignetes Einstellen der Edelgasumgebungsatmosphäre sowie der Zeitdauer Aussetzens lässt sich ein Einbringen von Atomen des Edelgases durch den Halbleiteroxidbereich in den Hohlraum des Halbleiterbauelements so steuern, dass sich anschließend ein gewünschter Druck innerhalb des Hohlraums einstellt.

Vorteilhaft ist an dem erfindungsgemäßen Verfahren zum Erzeugen eines vorgegebenen Innendrucks, dass das Verfahren von einem Zustand ausgeht, da die Hohlräume bereits gebildet sind. Dadurch kann das Verfahren sowohl auf Waferebene als auch an den bereits vereinzelten Chips bzw. auf Chipebene durchgeführt werden.

Ein weiterer Vorteil der vorliegenden Erfindung besteht darin, dass der Druck der Edelgasatmosphäre größer sein kann und vorzugsweise auch größer ist als der gewünschte Innendruck, so dass sich eine sehr homogene Einstellung des Innendrucks über eine große Anzahl von Halbleiterbauelementen, die beispielsweise auf einem Wafer angeordnet sein können, erzielen lässt. Anders ausgedrückt können die auf einem Wafer angeordneten Halbleiterbauelemente alle gleichmäßig von Neon umgeben sein. Hierdurch ist das erfindungsgemäße Verfahren zum Erzeugen eines vorgegebenen Innendrucks in einem Hohlraum eines Halbleiterbauelements sehr gut kontrollierbar. Gleichzeitig ermöglicht dies, die Einstellung des Innendrucks in einem Hohlraum auf einen vorgegebenen Wert in sehr effizienter Weise durchzuführen.

Die homogenere Verteilung des Innendrucks über eine Anzahl von Bauelementen, die in einem Ausführungsbeispiel der vorliegenden Erfindung beispielsweise auf einem Wafer angeordnet sind, führt dazu, dass ein größerer Anteil der Bauelemente eine elektrische Funktionalität zeigt, die in einem für den Einsatz der Bauelemente spezifizierten Bereich liegt. Dadurch ist die Ausbeute höher, was eine Verringerung der Fertigungskosten nach sich zieht gegenüber einem Bauelement, bei dem der Innendruck in dem Hohlraum nach einem herkömmlichen Verfahren eingestellt wird.

Darüber hinaus bietet die vorliegenden Erfindung die Möglichkeit, das Aussetzen des Halbleiterbauelementes gegenüber einer Edelgasatmosphäre durch beispielsweise Einbringens eines Edelgases in eine Prozesskammer, in welcher auch das Bauelement angeordnet ist, gleichzeitig als Feinstlecktest zu nutzen. Chips mit einer defekten Bondung werden nämlich, nachdem sie der Edelgasatmosphäre bzw. dem Überdruck ausgesetzt waren, einen deutlich zu großen Innendruck aufweisen. Hierdurch lassen sich Chips mit einer defekten Bondung sehr schnell in einem anschließenden Testverfahren erkennen. Entsprechendes gilt natürlich für Bauelemente auf Waferebene.

Insgesamt kann der Innendruck in dem Hohlraum des Halbleiterbauelements bei dem erfindungsgemäßen Verfahren sowohl auf Chipebene als auch auf Waferebene oder gar im Waferbatch eingestellt werden. Hierdurch zeigt dieses Verfahren eine sehr große Flexibilität.

Ein weiterer Vorteil des Verfahrens zum Erzeugen eines vorgegebenen Innendrucks in einem Hohlraum eines Halbleiterbauelements besteht darin, dass ein bei einem Ausführungsbeispiel der Erfindung eingesetzter Getter nicht zusätzlich belastet wird. Der Getter kann so ausgeführt sein, dass von ihm ein Edelgas nicht absorbiert wird. Darüber hinaus kann das Verfahren zum Erzeugen eines vorgegebenen Innendrucks in einem Hohlraum eines Halbleiterbauelements mit einer Aktivierung des Getters kombiniert werden. Dabei ist besonders vorteilhaft, dass während des Aussetzens die Temperatur und die Aussetzzeitdauer so eingestellt werden können, das der Getter aktiviert wird. Während sich der vorgegebene Innendruck in dem ersten Umgebungsatmosphärenzustand einstellt, entfernt der Getter gleichzeitig unerwünschte Gasatome in dem Hohlraum. Somit lassen sich in sehr effizienter Weise Halbleiterbauelemente herstellen, bei denen ein Innendruck in einem Hohlraum einen vorgegebenen Wert haben soll bzw. die eine vorbestimmte

Bevorzugte Ausführungsbeispiele der vorliegenden Erfindung werden nachfolgend Bezug nehmend auf die beiliegenden Zeichnungen näher erläutert. Es zeigen:
- Fig. 1: ein Halbleiterbauelement mit einem Hohlraum, bei dem ein Verfahren gemäß einem Ausführungsbeispiel der vorliegenden Erfindung einsetzbar ist;
- Fig. 2: ein Verfahren zum Erzeugen eines vorgegebenen Innendrucks in einem Hohlraum eines Halbleiterbauelements gemäß einem Ausführungsbeispiel der vorliegenden Erfindung;
- Fig. 3: einen Graphen mit Permeabilitätswerten für Permeationen verschiedener Gase durch Siliziumdioxid;
- Fig. 4: einen Graphen mit Permeabilitätswerte für Permeationen verschiedener Edelgase durch Siliziumdioxidschicht für teilweise verschiedene Differenzdrücke; und
- Fig. 5A und 5B: eine Gegenüberstellung einer Verteilung von Gütefaktoren bei einer bestimmten Menge an Mikrosensoren vor und nach einem Überdrucktest mit Helium.

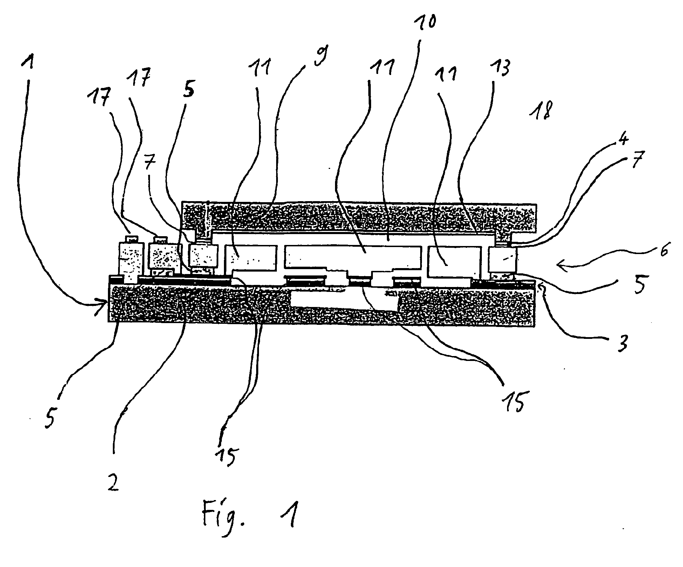

Fig. 1 zeigt ein Halbleiterbauelement mit einem Hohlraum, in welchem ein vorgegebener Innendruck erzeugt werden soll, wozu ein Verfahren gemäß einem Ausführungsbeispiel der vorliegenden Erfindung verwendbar ist.

Die Fig. 1 zeigt ein Substrat 2, auf dem eine strukturierte Schicht 3 aus Polysilizium aufgebracht ist, auf der wiederum Strukturen angeordnet sind, die Bereiche 5 aus Siliziumdioxid, elektrisch leitfähige Schichten, wie z.B. aus Polysilizium, 15 und eine strukturierte Schicht 6, wie z.B. eine epitaktische Polysiliziumschicht, aufweisen. Auf dieser Anordnung ist ein Substrat 9 angeordnet, das als Abdeckung dient, und auf dessen dem Substrat 2 zugewandten Seite wiederum eine strukturierte Siliziumoxidschicht 4 und darauf wiederum Bond-Metall, wie z.B. Gold, 7 aufgebracht ist. Über die Bondmetalle 7 ist die Abdeckung 9 mit der unteren Anordnung umfassend das Substrat 2 mechanisch verbunden. Lateral sind die Bereiche 7 aus Bondmetall bzw. die Bondbereiche derart angeordnet, dass durch das Substrat 2, die Siliziumdioxidschichten 4 und 5, die Bereiche 7, die Polysiliziumschicht 6 und die Abdeckung 9 ein Hohlraum 10 gebildet wird, der mehr oder weniger hermetisch dicht ist, wie es sich aus folgender Erörterung noch ergeben wird.

In dem Hohlraum 10 sind in der Polysiliziumschicht 6 Polysiliziumbereiche 11 gebildet, die beispielsweise eine mikromechanische Struktur, wie z.B. eine Schwingungs- oder Resonanzstruktur, definieren. An der Abdeckung 9 ist auf der dem Substrat 2 zugewandten Oberfläche derselben innerhalb des Hohlraums 10, d.h. im Inneren des Hohlraums, ein Getter 13 angeordnet.

In Fig. 1 ist eine mittlerer der Polysiliziumbereiche 11 exemplarisch derart dargestellt, dass er auf einer elektrisch leitfähigen und auf der Schicht 3 angeordneten Schicht 15 angeordnet und damit kontaktierbar bzw. auf ein Potential legbar ist, während Teile dieses mittleren Bereiches sich schwebend über weitere leitfähige Abschnitte der Schicht 15 erstrecken, so dass durch Anlegen von Spannungen zwischen letzteren Abschnitten der Schicht 15 und dem mittleren Siliziumbereich 11 mechanische Biege- oder Schwingungsbewegungen hervorrufbar sind.

Außerhalb der Anordnung, die den Hohlraum 10 umschließt, sind zwei Anschlussflächen, wie z.B. Aluminiumpads, 17 angeordnet. Einer der beiden Aluminiumpads 17 ist elektrisch mit dem Substrat 2 gekoppelt, während der andere Aluminiumpad 17 über die leitfähige Schicht 15 mit einem weiteren der Polysiliziumbereiche 11 elektrisch gekoppelt ist, der von dem frei beweglichen Ende des Auslegers des mittleren Bereiches 11 über einen Spalt beabstandet ist und somit durch Einstellen einer Potentialdifferenz zwischen den beiden benachbarten Bereichen beispielsweise zur Feineinstellung der Resonanzfrequenz dienen kann.

Wie es zu erkennen ist, erstreckt sich zwischen dem Hohlraum 10 und dem Äußeren 18 des gezeigten Halbleiterbauelements eine durchgängiger Weg aus Siliziumdioxid bei 4 und 5. Bei dem im folgenden beschrieben Verfahren zur Einstellung eines gewünschten Innendrucks in dem Hohlraum 10 wird nun von dem durchgängigen Weg und von der Eigenschaft von Siliziumdioxid Gebrauch gemacht, dass dasselbe unter bestimmten Bedingungen für ein in der Umgebung 18 des Halbleiterbauelement befindliches Edelgas eine höhere Permeabilität aufweist als bei anderen Bedingungen.

Zu Fig. 1 sei erwähnt, dass bei der Bereitstellung bzw. Herstellung des Halbleiterbauelementes von Fig. 1, ein Vielzahl solcher Bauelemente gemeinsam beispielsweise dadurch erzeugt werden, dass auf einem Wafer 2 an einer Vielzahl von Bereichen Strukturen 3, 5, 6 erzeugt werden, wie sie im vorhergehenden beschrieben wurden, und dass dann eine Vielzahl von Abdeckungen 9 in auf einem weiteren Wafer angeordnetem Zustand derart mit diesen Strukturen gebondet werden, dass die Hohlräume 10 entstehen, wobei beispielsweise der Druck, unter welchem das Bonden stattfindet, kleiner ist, als der Druck, der gewünscht ist und anschließend durch das im folgenden erläuterte Verfahren eingestellt werden soll. Dabei kann das folgende Verfahren sowohl auf die einzelnen Bauelemente in ihrem vereinzelten Zustand, d.h. auf Bauelementchips, und zwar einzeln oder in Gruppen, oder auf den Wafer 2 in mit den Abdeckungen 9 versehenen Zustand angewendet werden.

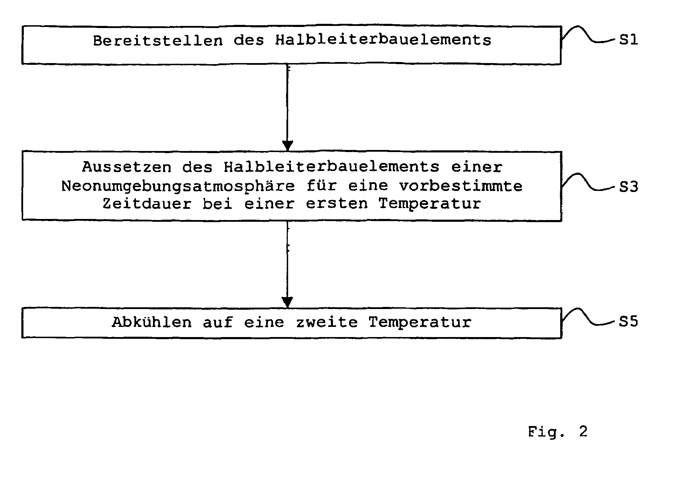

Fig. 2 erläutert im Folgenden ein Verfahren zum Erzeugen des vorgegebenen bzw. gewünschten Innendrucks in dem Hohlraum 10 in dem in Fig. 1 gezeigten Halbleiterbauelement.

In einem Schritt S1 wird das Halbleiterbauelement bereitgestellt, wie es beispielsweise in Fig. 1 gezeigt und beschrieben wurde.

Anschließend wird das Halbleiterbauelement in einem Schritt S3 einer Neonumgebungsatmosphäre für eine vorbestimmte Zeitdauer bei einer ersten Temperatur ausgesetzt, bei welcher das Neon durch das Siliziumdioxid diffundieren kann. Dazu wird das Bauelement beispielsweise in eine Prozesskammer eingebracht, woraufhin Neon in die Prozesskammer eingebracht wird, so dass sich das Halbleiterbauelement in einer Umgebungsatmosphäre befindet, die zumindest Neongas aufweist. Während des Aussetzens wird eine Temperatur bzw. Umgebungstemperatur der Umgebungsatmosphäre innerhalb der Kammer beispielsweise auf einen Wert zwischen 200 und 700°C und vorzugsweise auf einen Wert zwischen 300 und 400°C eingestellt. Ein Druck in der Prozesskammer während des Aussetzens wird beispielsweise auf einen Wert zwischen 2 und 20 und vorzusgweise auf einen Wert im Bereich von 3 bis 7 bar und besonders bevorzugt auf 4 bar eingestellt. Die so eingestellte Temperatur und der so eingestellte Druck in der Kammer wird über eine Zeitdauer beibehalten, während sich das Bauelement in der so eingestellten Neonatmosphäre befindet. In dieser Zeitdauer dringt bzw. diffundiert Neon über den vorerwähnten durchgängigen Weg, der sich innerhalb des Siliziumdioxids zwischen der freiliegenden Außenoberfläche des Bauelementes und dem Hohlrauminneren erstreckt, in den Hohlraum, wobei die Diffusionsgeschwindigkeit von der Differenz zwischen dem Innendruck innerhalb des Bauelementhohlraums und dem Druck in der Prozesskammer abhängt, weshalb der gewünschte Innendruck durch geeignete Wahl der Aussetzzeitdauer und den Kammdruck eingestellt werden kann. Die Aussetzzeitdauer liegt beispielsweise zwischen 30 und 240 Minuten.

Es sei darauf hingewiesen, dass es gegebenenfalls möglich wäre, nicht die gesamte Neonumgebungstemperatur in der Prozesskammer während des Aussetzens S3 auf die oben erwähnte Permeationstemperatur einzustellen. Vielmehr wäre es beispielsweise ferner möglich ein lokale Erhitzung des oder an dem Siliziumdioxid vorzunehmen, wie z.B. durch gegebenenfalls eigens hierfür vorgesehene Widerstandbahnen, die entlang und in geringer Entfernung zu den durchgängigen Wegen verlaufen, die sich innerhalb des Siliziumdioxids zwischen dem Hohlrauminneren und Außen erstrecken.

Anders ausgedrückt baut sich in dem Hohlraum 10 des Halbleiterbauelements ein Innendruck auf. Dieser Innendruck entsteht dadurch, dass Partikel bzw. Atome des in der Prozesskammer befindlichen Neons durch die Siliziumdioxidschichten 4,5 in den Hohlraum 10 diffundieren. Hierbei macht man sich die Eigenschaften der Siliziumdioxidschichten 4,5 zu nutze, dass diese unter den in der Prozesskammer eingestellten Bedingungen für das Neon eine höhere Permeabilität aufweisen als in einem Sollverwendungsbereich bzw. in zugelassenen Betriebsbedingungen des Halbleiterbauelements, die typischer Weise zwischen 120°C nicht überschreiten.

Anschließend wird in einem Schritt S5 das Aussetzen S3 beendet bzw. die Temperatur von der Permeationstemperatur auf eine kühlere Temperatur umgestellt, bei der keine Diffusion von Neon durch das Siliziumdioxid stattfindet. Die geschieht beispielsweise einfach durch Herausnehmen des Halbleiterbauelements aus der Prozesskammer nach Ablauf der vorbestimmten Zeitdauer. Unter den Normalbedingungen außerhalb der Prozesskammer ist die Temperatur kühler, so dass die Permeabilität der Siliziumdioxidschichten 4,5 für das Neon erheblich niedriger als unter den in der Prozesskammer eingestellten Umgebungsatmosphärenzustand bzw. Bedingungen der Umgebungsatmosphäre ist, bzw. annähernd null ist. Die Neonatome, die während des Prozessierens des Halbleiterbauelements in den Hohlraum 10 eingedrungen sind, verbleiben also unter den Bedingungen des Sollverwendungsbereichs in dem Hohlraum 10, so dass der von der Konzentration der Neonatome in dem Hohlraum 10 abhängige Innendruck unter den Bedingungen des Sollverwendungsbereichs über die Lebensdauer des Halbleiterbauelements hinweg annähernd konstant bleibt.

Nach dem Schritt S5 könnte der Hohlraum beispielsweise im Rahmen eines Packungsschrittes endgültig durch ein Verkapselungsmaterial hermetisch dicht abgeschlossen werden, das beispielsweise insbesondere die freiliegenden Stellen des Siliziumdioxids bedeckt, um jeglichen durchgängigen Weg zwischen dem Hohlrauminneren und Außen im Siliziumdioxid zu verhindern.

Eine Bestimmung des Innendrucks in dem Hohlraum nach einer Durchführung einer erfindungsgemäßen Prozessierung von Halbleiterbauelementen bei einem Druck von Neon von 4 bar, einer Neontemperatur von 300°C und einer Aussetz- bzw. Einwirkzeitdauer von 60 min hat beispielsweise gezeigt, dass der in dem Hohlraum 10 vorhandene Innendruck um einen Wert von 10 Pascal liegt.

In obigem Ausführungsbeispiel der vorliegenden Erfindung ist die Permeabilität von Siliziumdioxid bezüglich Neon ausgenutzt worden. Ähnliche Diffusionseffekte bzw. Permeabilitätsschwankungen abhängig von der Temperatur könnten aber auch bei anderen Kombinationen aus Edelgasen und Halbleiteroxiden festgestellt werden. Bei Neon mit Siliziumdioxid liegt die Permeabilität während des Aussetzens bevorzugt um einen Faktor in einem Bereich von 500 bis 5000 höher als bei Normalbedingungen bzw. bei dem zugelassenen Betriebstemperaturbereich oder beispielsweise bei 85°C als Referenz.

In dem obigen Ausführungsbeispiel der vorliegenden Erfindung wurde eine Temperatur in einem Bereich um 300°C bevorzugt. Jedoch können beliebige Temperaturen in der Prozesskammer eingestellt werden, bei denen die Atome des Neons die Siliziumdioxidschichten 4,5 durchdringen können.

In dem obigen Ausführungsbeispiel der vorliegenden Erfindung sind das Substrat 2 und die Abdeckung 9 und die auf ihnen befindlichen Schichten über einen Metallbond 7 miteinander mechanisch verbunden. Alternativen sind hierzu jedoch beliebige Verbindungen, wie beispielsweise Siliziumbonden oder Siliziumdioxidbonden oder Fügungen mittels Glas- oder Metallloten.

In dem obigen Ausführungsbeispiel der vorliegenden Erfindung wurde ein Druck von 4 bar in der Prozesskammer bevorzugt, jedoch können beliebige Drücke in der Umgebung eingestellt werden, bei denen die Atome des Neongases die Siliziumdioxidschicht durchdringen können, und damit von der Umgebung des Halbleiterbauelements in den Hohlraum 10 eindringen können.

Das Halbleiterbauelement wurde in dem vorerwähnten Versuch gemäß einem Ausführungsbeispiel der vorliegenden Erfindung über einen Zeitraum in einem Bereich um eine Stunde hinweg in der Prozesskammer unter den oben erwähnten Bedingungen prozessiert. Jedoch sind beliebige Zeiträume denkbar, um den Druck in dem Hohlraum 10 auf einen vorgegebenen Wert einzustellen. Dabei liegt der Zeitraum bzw. die Zeitdauer, in der das Prozessieren des Halbleiterbauelements durchgeführt wird unter dem in der Prozesskammer eingestellten Zustand der Umgebungsatmosphäre bevorzugt in einem Bereich von 20 min bis 20 h und noch bevorzugter in einem Bereich um 1h.

In dem oben aufgeführten Beispiel des Verfahrens gemäß der vorliegenden Erfindung wurde ein Innendruck von 10 Pa in dem Hohlraum 10 in dem Halbleiterbauelement eingestellt. Jedoch sind durch das Verfahren beliebige Innendrücke in dem Hohlraum 10 einstellbar, die niedriger sind als der in der Prozesskammer herrschende Druck während dem Prozessieren des Halbleiterbauelements. Bevorzugt wird jedoch ein Innendruck in einem Bereich von 0,01 Pa bis 100 Pa und noch bevorzugter in einem Bereich um 10 Pa eingestellt.

In obigem Ausführungsbeispiel der vorliegenden Erfindung dringt das Neon über die in Fig. 1 gezeigten Siliziumdioxidschichten in den Hohlraum 10 des Halbleiterbauelements ein. Alternativ können jedoch auch beliebige Halbleiteroxidschichten zwischen dem Hohlraum 10 und der Umgebung des Hableiterbauelements angeordnet sein, die während dem Prozessieren in der Prozesskammer eine höhere Permeabilität für ein Edelgas als unter den Umgebungsbedingungen des Sollwertbereichs aufweisen.

In obigem Ausführungsbeispiel der vorliegenden Erfindung ist das Halbleiterbauelement beispielsweise ein verkapselter Mikroresonator oder ein verkapseltes Vibrationsgyroskop, jedoch sind beliebige Halbleiterbauelemente mit einen Hohlraum Alternativen.

Vorteilhafterweise wird während des Prozessierens des Halbleiterbauelements in der Prozesskammer gleichzeitig eine Getteraktivierung vorgenommen, wie z.B. des Getters 13 in Fig. 1, wobei eine Getteraktivierung beispielsweise eine Wirktemperatur von 350°C über eine Zeitdauer von 30min benötigt. Der Getter 13 ist dabei vorzugsweise eine Zirkonium und/oder Titan enthaltende Schicht, die in dem Hohlraum 10 befindliche Gasatome absorbiert. Verzugsweise werden die während des Verfahrens in dem Hohlraum 10 eindringenden Neongasatome nicht von dem Getter 13 absorbiert. Dies führt dazu, dass sich nach der Durchführung des in Fig. 2 gezeigten Verfahrens gemäß einem Ausführungsbeispiel der vorliegenden Erfindung vornehmlich Neongasatome in dem Hohlraum 10 befinden. Somit lässt sich der Innendruck in dem Hohlraum 10 in effizienter Weise auf einen vorgegebenen Wert einstellen.

In dem in Fig. 2 gezeigten Verfahren gemäß einem Ausführungsbeispiel der vorliegenden Erfindung macht man sich die Eigenschaften von Neon zur Abstimmung bzw. Einstellung des Innendrucks in dem Hohlraum 10 eines Halbleiterbauelements wie beispielsweise eines Sensors zu nutze. Dies kann vorteilhafterweise nach dem Bonden eines Halbleiterbauelements bzw. sogar nach dem Vereinzeln des Halbleiterbauelements erfolgen. Unter dem Bonden des Halbleiterbauelements versteht man den Herstellungsschritt, bei dem die Abdeckung 9 und die auf ihr angeordneten Schichten durch beispielsweise, wie im Fall von Fig. 1, Verbinden von Gold 5 mit Silizium 6 oder das Verschmelzen zweier Bondmetalle, die jeweils auf der Materialstruktur mit dem Substrat 2 bzw. auf der Materialstruktur mit der Abdeckung 9 angeordnet sind, so dass der Hohlraum 10 entsteht, und zwar gemäß vorliegender Erfindung eben so, dass sich ein Halbleiteroxidbereich ununterbrochen zwischen dem Hohlraum 10 und Außen erstreckt.

Von besonderem Vorteil bei dem in Fig. 2 gezeigten Verfahren ist die Tatsache, dass die Halbleiterbauelemente nach dem Bonden frei zugänglich sind, d.h. das Neongas kann die Halbleiterbauelemente mit den Hohlräumen 10 auf dem Wafer bei dem Einstellen des Innendrucks allseitig umspülen bzw. umströmen, wodurch Inhomogenitäten, wenn das Halbleiterbauelement auf einem Wafer angeordnet ist, vermieden werden können.

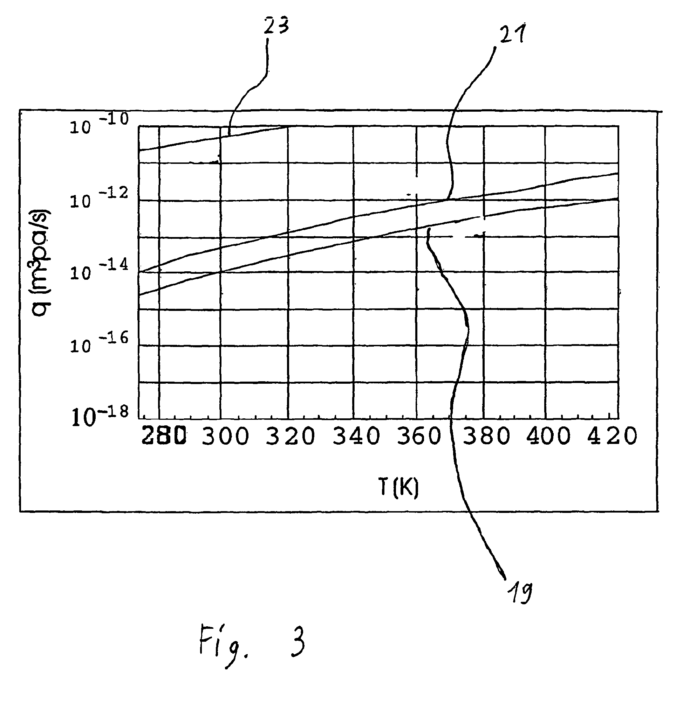

Fig. 3 veranschaulicht die Temperaturabhängigkeit der Permeabilitätswerte für Wasserstoff un die Edelgase He und Ne bezogen auf Siliziumdioxid bei 4 bar. Auf der x-Achse ist die Temperatur linear in Kelvin aufgetragen, während auf der y-Achse die Permeabilität logarithmisch in m³ Pa/sec aufgetragen ist. Eine Kurve 19 erläutert einen Verlauf der Permeabilität für Neon, eine Kurve 21 einen Verlauf der Permeabilität für Wasserstoff und eine Kurve 23 einen Verlauf der Permeabilität für Helium jeweils bei einem Umgebungsdruck von 4 bar. Die Permeabilität ist dabei ein Maß, wie schnell die jeweiligen Gase in beispielsweise den Hohlraum 10 des in Fig. 1 gezeigten Halbleiterbauelements diffundieren bzw. eindringen können.

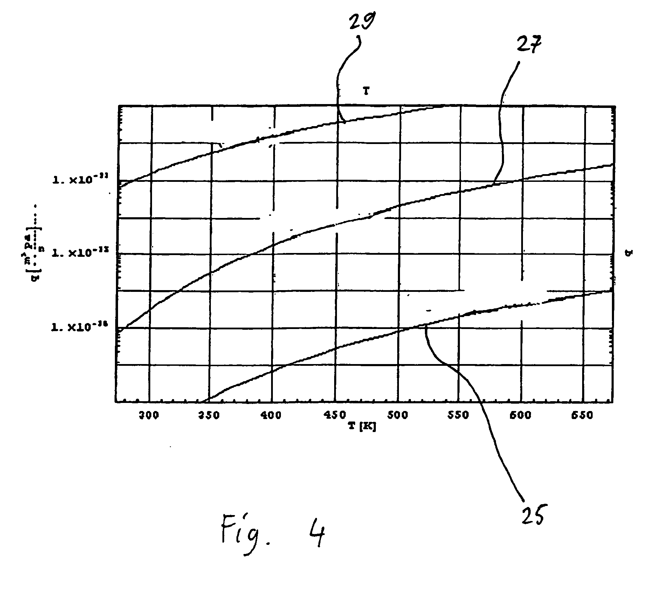

Die Permeabilität für alle dargestellten Gase ist von der Temperatur abhängig und nimmt mit steigender Temperatur bzw. Umgebungstemperatur an dem Halbleiterbauelement exponentiell zu. Fig. 3 zeigt auch, dass Helium eine höhere Permeabilität als Wasserstoff aufweist, der wiederum eine höhere Permeabilität als Neon aufweist. Bei einer Temperatur von ca. 330°C erreicht Neon (siehe Fig. 4) aufgrund der Zunahme der Permeabilität mit der Temperatur den selben Wert wie Helium bei Raumtemperatur. Aus dem in Fig. 3 gezeigten Kurvenverlauf ist außerdem zu erkennen, dass Helium etwa 5.000 mal schneller in den Hohlraum 10 diffundiert als Neon.

Eine genauere Analyse der Verhältnisse zeigt, dass die Permeation von Neon bei 300°C - 400°C groß genug ist, um den Druck in einer relativ kurzen Zeitspanne, vorzugsweise einigen Stunden, einstellen zu können, andererseits aber die Permeation im Bereich der Raumtemperatur fast nicht messbar und klein genug ist, um nennenswerte Neonverluste auch über einen Zeitraum von 10 bis 15 Jahren bei einem angestrebten Innendruck von beispielsweise 10-40 Pascal zu vermeiden.

Fig. 4 veranschaulicht die Temperaturabhängigkeit der Permeabilitätswerte für Neon und Helium an dem Halbleiterbauelement bezüglich Siliziumdioxid teilweise für verschiedene Differenzdrücke zwischen Kammer und Hohlrauminneren. Auf dem in Fig. 4 gezeigten Graphen sind auf der x-Achse die Temperaturwerte in linearem Maßstab aufgetragen, während auf der y-Achse die Permeabilitätswerte in logarithmischem Maßstab aufgetragen sind. Ein Kurvenverlauf 25 erläutert die Permeabilität für Neon bei einer Druckdifferenz von 0,4 mbar, während ein Kurvenverlauf 27 die Permeabilität für Neon bei einer Druckdifferenz von 1 bar zeigt. Ein Kurvenverlauf 29 stellt die Permeabilität für Helium bei einer Druckdifferenz von 1 bar dar.

Zu erkennen ist, dass die Permeabilität von der Druckdifferenz abhängt, d.h. bei einer bestimmten Temperatur die Permeabilität von Neon bei einer Druckdifferenz von 1 bar erheblich höher ist als bei einer Druckdifferenz von 0,4 mbar. Die Druckdifferenz tritt dabei zwischen dem in dem Hohlraum 10 befindlichen Innendruck und einem Umgebungsdruck auf. Aus dem Graphen in Fig. 4 ist auch zu erkennen, dass die Permeation bei Raumtemperatur bzw. unter Umgebungsbedingungen in einem Sollverwendungsbereich des Halbleiterbauelements in einem für die Funktionalität des Halbleiterbauelements erforderlichen Bereich liegen. Das heißt, dass die Permeation in dem Sollverwendungsbereich des Halbleiterbauelements so hoch ist, dass über die Lebensdauer des Halbleiterbauelements, die beispielsweise in einem Bereich von 10 a bis 15 a liegt, hinweg nur in geringem Umfang Neongasatome aus dem Hohlraum 10 durch die Siliziumdioxidschichten 4,5 in die Umgebung des Halbleiterbauelements diffundieren bzw. austreten. Somit bleibt der in dem Hohlraum 10 erzeugte vorgegebene Innendruck über die Lebensdauer des Halbleiterbauelements annähernd konstant.

Unter dem Sollverwendungsbereich des Halbleiterbauelements versteht man die Umgebungsbedingungen, unter denen das Halbleiterbauelement gemäß den spezifizierten Werten eingesetzt werden kann, oder für die der Einsatz bzw. Betrieb bestimmungsgemäß vorgesehen ist. Diese sind typischerweise ein Atmosphärendruck in einem Bereich um 1 bar und in einem Temperaturbereich von -50°C bis 130°C oder in kleinerem Bereich.

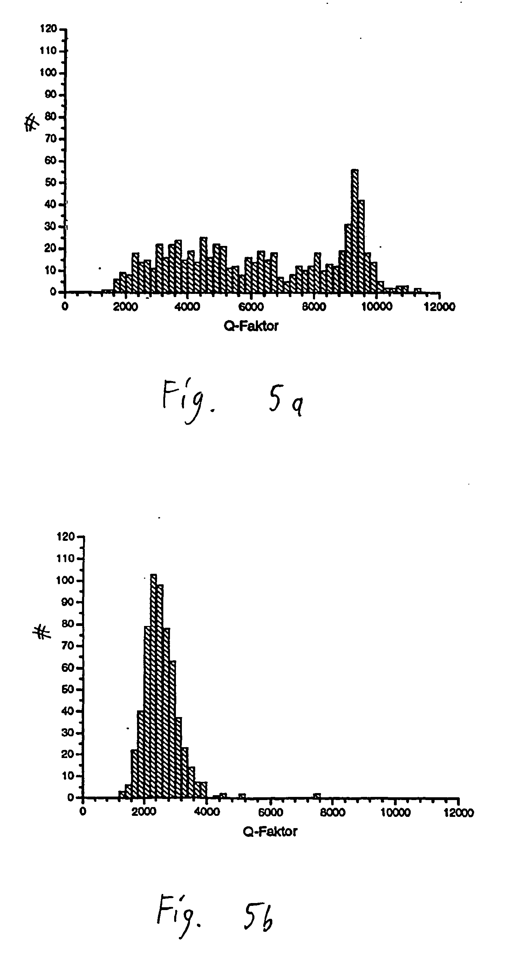

Um zu veranschaulichen, welche positive Auswirkung das Verfahren von Fig. 2 auf die Schwankung des Innenraumdrucks gleich prozessierter Bauelemente aufweist, zeigen Fig. 5a-B eine Gegenüberstellung einer Verteilung der Güte bzw. des Gütefaktors in einer vorgegebenen Menge von beispielsweise gemäß Fig. 1 verkapselten Mikroresonatoren vor bzw. nach einem Überdrucktest mit Helium, also einem Test, bei welchem einer Überdruckatmosphäre Helium in die Hohlräume eindringt. Da die Mikrosensoren nicht komplett nur mit Silizium sondern auch abschnittsweise Isolationsschichten aus SiO₂ aufweisen (vgl. Fig. 1), lässt sich das Eindringen von Helium während einer Überdrucktestes beobachten.

In Fig. 5A ist die Verteilung der Güte bzw. des Q-Faktors innerhalb der Menge der Mikroresonatoren vor dem Heliumtest dargestellt, während in Fig. 5B die Verteilung der Güte der Mikroresonatoren nach dem Heliumtest dargestellt ist.

Auf der x-Achse sind die Bereichsgrenzen der Güte aufgetragen, innerhalb derer eine auf der y-Achse aufgetragene Anzahl an Mikroresonatoren aus der Menge der Mikroresonatoren liegt. In Fig. 5B sind ebenfalls auf der x-Achse die Bereichsgrenzen aufgetragen, innerhalb derer eine Güte liegt, während auf der y-Achse wiederum die Anzahl der Mikroresonatoren aufgetragen ist, die eine Güte in dem entsprechenden Bereich aufweisen.

Die Mikroresonatoren bzw. Mikrosensoren sind dabei in dem Hohlraum 10 angeordnet, in dem durch das Eindringen von Helium während eines Überdrucktests der Innendruck auf einen vorgegebenen Wert eingestellt wird. Das Helium dringt dabei überwiegend über die Siliziumdioxidschichten 4,5 in den Hohlraum 10 ein.

Fig. 5B zeigt, dass durch das Einstellen des Innendrucks in dem Hohlraum 10 während dem Überdrucktest mit Helium eine homogenere Verteilung der Güte der Mikroresonatoren erzielt werden kann. Während in Fig. 5A eine nennenswerte Menge von Mikroresonatoren, eine Güte in einem Bereich zwischen ca. 2.000 und ca. 10.000 zeigten, konzentriert sich die Güte der Mikroresonatoren nach dem Überdrucktest mit Helium in einem Bereich zwischen 1.600 und 4.000.

Die Güte ist dabei in hohem Maß von dem Innendruck in dem Hohlraum 10 abhängig. Somit ist die Verteilung der Güte über die Menge der untersuchten Mikroresonatoren ein Maß für die Verteilung des Innendrucks über die Menge der untersuchten Mikroresonatoren, und der Innendruck der Sensoren kann aus der Dämpfung und der daraus resultierenden Güte der Resonatoren abgeleitet werden.

Die Verteilung der Güte und damit des Innendrucks in dem Hohlraum 10 in der untersuchten Menge an Mikroresonatoren ist nach dem Heliumtest homogener, d. h. die Uniformität des Innendrucks in den Hohlräumen der jeweiligen Mikroresonatoren ist höher. Anders ausgedrückt sind nach dem Heliumtest die Schwankungen der Güte zwischen den einzelnen Mikroresonatoren der untersuchten Menge geringer. Durch den Heliumtest wurde somit in dem Hohlraum 10 ein Innendruck eingestellt. Zur Dauerhaften Verwendung der Bauelemente nach dem Heliumtest müssen diese aber anschließend in einem äußerst niedrigem Temperaturbereich behandelt werden, um Verluste weiteren Heliums zu verhindern.

Es wird darauf hingewiesen, dass ähnlich zu den im vorhergehenden beschriebenen Vorgehensweise das Neon nach einer erfolgten Überfüllung auch wieder in einer temperierten Vakuumkammer aus dem Innenvolumen der Halbleiterbauelemente entfernt werden kann, wozu allerdings die Aussetzungszeit unter Umständen einige Tage in Anspruch nehmen kann.

## Patentansprüche

1. Verfahren zum Erzeugen eines vorgegebenen Innendrucks in einem Hohlraum (10) eines Halbleiterbauelements, mit folgenden Schritten:
Bereitstellen (S1) des Halbleiterbauelements, wobei das Halbleiterbauelement einen Halbleiteroxidbereich (4, 5) aufweist, der durchgängig zwischen dem Hohlraum (10) des Halbleiterbauelements und einer Außenoberfläche des Halbleiterbauelements angeordnet ist;
Aussetzen (S3) des Halbleiterbauelements einer Umgebungsatmosphäre mit einem Edelgas bei einer ersten Temperatur für eine vorbestimmte Zeitdauer; und
Einstellen (S5) einer zweiten zu der ersten unterschiedlichen Temperatur nach Ablauf der vorbestimmten Zeitdauer,
wobei der Halbleiteroxidbereich (4, 5) bei der ersten Temperatur eine höhere Permeabilität für das Edelgas aufweist als bei der zweiten Temperatur,
**dadurch gekennzeichnet, dass** der Schritt des Aussetzens derart durchgeführt wird, dass das Edelgas Neon ist.

2. Verfahren gemäß Anspruch 1, bei dem der Schritt des Aussetzens des Halbleiterbauelements der Umgebungsatmosphäre folgende Teilschritte aufweist:
Einstellen eines vorbestimmten Umgebungsdrucks und einer vorbestimmten Umgebungstemperatur in der Umgebungsatmosphäre für die vorbestimmte Zeitdauer.

3. Verfahren gemäß Anspruch 2, bei dem der Schritt des Einstellens des Umgebungsdrucks und der Umgebungstemperatur derart durchgeführt wird, dass der vorbestimmte Umgebungsdruck in einem Bereich von 2 bar bis 20 bar liegt.

4. Verfahren gemäß einem der Ansprüche 2 oder 3, bei dem der Schritt des Einstellens des Umgebungsdrucks und der Umgebungstemperatur derart durchgeführt wird, dass die vorbestimmte Umgebungstemperatur in einem Bereich von 200°C bis 700°C liegt.

5. Verfahren gemäß einem der Ansprüche 2 oder 3, bei dem der Schritt des Einstellens des Umgebungsdrucks und der Umgebungstemperatur derart durchgeführt wird, dass die vorbestimmte Umgebungstemperatur in einem Bereich von 300°C bis 400°C liegt.

6. Verfahren gemäß einem der vorhergehenden Ansprüche, bei dem der Schritt des Aussetzens derart durchgeführt wird, dass die vorbestimmte Zeitdauer in einem Bereich von 20 Minuten bis 20 Stunden liegt.

7. Verfahren gemäß einem der Ansprüche 1 - 6, bei dem der Schritt des Aussetzens derart durchgeführt wird, dass die vorbestimmte Zeitdauer in einem Bereich von 20 bis 240 Minuten liegt.

8. Verfahren gemäß einem der vorhergehenden Ansprüche, bei dem der Schritt des Bereitstellens derart durchgeführt wird, dass der Halbleiteroxidbereich Siliziumdioxid aufweist.

9. Verfahren gemäß einem der vorhergehenden Ansprüche, bei dem das Edelgas, ein Halbleiteroxid des Halbleiteroxidbereiches und die erste und zweite Temperatur derart ausgewählt sind, dass die Permeabilität für das Edelgas bei der ersten Temperatur um einen Faktor in einem Bereich von 500 bis 50.000 höher ist als bei der zweiten Temperatur.

10. Verfahren gemäß einem der vorhergehenden Ansprüche, bei dem der Schritt des Aussetzens derart durchgeführt wird, dass der vorgegebene Innendruck in einem Bereich von 0,01 Pa bis 100 Pa liegt.

11. Verfahren gemäß einem der vorhergehenden Ansprüche, bei dem der Schritt des Bereitstellens das Bereitstellen einer Anordnung von mehreren Halbleiterbauelementen auf einem Wafer umfasst, und die Schritte des Aussetzens und Einstellens der Temperatur für alle Halbleiterbauelemente gemeinsam durchgeführt werden.

12. Verfahren gemäß einem der vorhergehenden Ansprüche 1 bis 10, bei dem der Schritt des Bereitstellens derart durchgeführt wird, dass ein Druck in dem Hohlraum (10) vor dem Schritt des Aussetzens geringer ist als der vorgegebene Innendruck.

13. Verfahren gemäß einem der vorhergehenden Ansprüche, bei dem der Schritt des Bereitstellens das Anordnen eines Gettermaterials innerhalb des Hohlraums zum, bei Aktivierung, Absorbieren eines anderen Gases als dem Edelgas in der Umgebungsatmosphäre aufweist, wobei der Schritt des Aussetzens zumindest derart durchgeführt wird, dass das Gettermaterial aktiviert wird.

14. Verfahren gemäß einem der vorhergehenden Ansprüche, bei dem das Bereitstellen derart durchgeführt wird, dass das Halbleiterbauelement ein mikromechanisches Bauelement aufweist.

15. Verfahren gemäß einem der vorhergehenden Ansprüche, bei dem das Bereitstellen derart durchgeführt wird, dass das Halbleiterbauelement einen Mikroresonator oder ein Vibrationsgyroskop aufweist.

16. Verfahren gemäß einem der vorhergehenden Ansprüche, bei dem der Schritt des Einstellens derart durchgeführt wird, dass die Temperatur nach Ablauf der vorbestimmten Zeitdauer in einem Bereich von -50°C bis 130°C liegt.

17. Verfahren gemäß einem der vorhergehenden Ansprüche, bei dem der Schritt des Einstellens derart durchgeführt wird, dass die Temperatur nach Ablauf der vorbestimmten Zeitdauer in einem Bereich liegt, die dem Sollverwendungstemperaturbereich des Halbleiterbauelements entspricht.

18. Verfahren gemäß einem der vorhergehenden Ansprüche, bei dem der Schritt des Einstellens ferner das Einstellen eines Umgebungsdrucks aufweist, um in einem Bereich von 0,9 Bar bis 1,2 Bar zu liegen.

## Claims

1. Method of creating a predefined internal pressure within a cavity (10) of a semiconductor device, comprising:
providing (S1) the semiconductor device, the semiconductor device comprising a semiconductor oxide area (4, 5) which is continuously arranged between the cavity (10) of the semiconductor device and an external surface of the semiconductor device;
exposing (S3) the semiconductor device to an ambient atmosphere with a noble gas at a first temperature for a predetermined time period; and
setting (S5) a second temperature, which is different from the first, after the predetermined time period has expired,
wherein the semiconductor oxide area (4, 5) exhibits a higher permeability for the noble gas at the first temperature than at the second temperature,
**characterized in that** the step of exposing is performed such that the noble gas is neon.

2. Method as claimed in claim 1, wherein the step of exposing the semiconductor device to the ambient atmosphere comprises the following substeps:
setting a predetermined ambient pressure and a predetermined ambient temperature within the ambient atmosphere for the predetermined time period.

3. Method as claimed in claim 2, wherein the step of setting the ambient pressure and the ambient temperature is performed such that the predetermined ambient pressure ranges from 2 bar to 20 bar.

4. Method as claimed in one of claims 2 or 3, wherein the step of setting the ambient pressure and the ambient temperature is performed such that the predetermined ambient temperature ranges from 200°C to 700°C.

5. Method as claimed in one of claims 2 or 3, wherein the step of setting the ambient pressure and the ambient temperature is performed such that the predetermined ambient temperature ranges from 300°C to 400°C.

6. Method as claimed in any of the previous claims, wherein the step of exposing is performed such that the predetermined time duration ranges from 20 minutes to 20 hours.

7. Method as claimed in any of claims 1 - 6, wherein the step of exposing is performed such that the predetermined time period ranges from 20 to 240 minutes.

8. Method as claimed in any of the previous claims, wherein the step of providing is performed such that the semiconductor oxide area comprises silicon dioxide.

9. Method as claimed in any of the previous claims, wherein the noble gas, a semiconductor oxide of the semiconductor oxide area, and the first and second temperatures are selected such that the permeability for the noble gas is higher by a factor ranging from 500 to 50,000 at the first temperature than at the second temperature.

10. Method as claimed in any of the previous claims, wherein the step of exposing is performed such that the predefined internal pressure ranges from 0,01 Pa to 100 Pa.

11. Method as claimed in any of the previous claims, wherein the step of providing comprises providing an arrangement of several semiconductor devices on a wafer, and the steps of exposing and setting the temperature for all semiconductor devices are jointly performed.

12. Method as claimed in any of previous claims 1 to 10, wherein the step of providing is performed such that prior to the step of exposing, a pressure within the cavity (10) is lower than the predetermined internal pressure.

13. Method as claimed in any of the previous claims, wherein the step of providing comprises arranging a getter material within the cavity for, during activation, absorbing a different gas than the noble gas within the ambient atmosphere, the step of exposing being performed at least such that the getter material is activated.

14. Method as claimed in any of the previous claims, wherein the providing is performed such that the semiconductor device comprises a micromechanical device.

15. Method as claimed in any of the previous claims, wherein the providing is performed such that the semiconductor device comprises a microresonator or a vibrating gyroscope.

16. Method as claimed in any of the previous claims, wherein the step of setting is performed such that the temperature ranges from -50°C to 130°C after the predetermined time period has expired.

17. Method as claimed in any of the previous claims, wherein the step of setting is performed such that after the predetermined time period has expired, the temperature lies within a range corresponding to the target application temperature range of the semiconductor device.

18. Method as claimed in any of the previous claims, wherein the step of setting further comprises setting an ambient pressure to range from 0.9 bar to 1.2 bar.

## Revendications

1. Procédé pour générer une pression interne prédéterminée dans une cavité (10) d'un composant à semi-conducteur, aux étapes suivantes consistant à:
préparer (S1) le composant à semi-conducteur, le composant à semi-conducteur présentant une zone d'oxyde semi-conducteur (4, 5) qui est disposée de manière traversante entre la cavité (10) du composant à semi-conducteur et une surface extérieure du composant à semi-conducteur;
soumettre (S3) le composant à semi-conducteur à une atmosphère ambiante avec un gaz inerte à une première température pendant une durée prédéterminée; et
régler (S5) une deuxième température, différente de la première, après écoulement de la durée prédéterminée,
la zone d'oxyde semi-conducteur (4, 5) présentant à la première température une perméabilité au gaz inerte supérieure qu'à la deuxième température,
**caractérisé par le fait que** la soumission est réalisée de sorte que le gaz inerte soit du néon.

2. Procédé selon la revendication 1, dans lequel l'étape de soumission du composant à semi-conducteur à l'atmosphère ambiante présente les étapes partielles suivantes:
régler une pression ambiante prédéterminée et une température ambiante prédéterminée dans l'atmosphère ambiante pendant la durée prédéterminée.

3. Procédé selon la revendication 2, dans lequel l'étape de réglage de la pression ambiante et de la température ambiante est réalisée de sorte que la pression ambiante prédéterminée se situe dans une plage de 2 bars à 20 bars.

4. Procédé selon l'une des revendications 2 ou 3, dans lequel l'étape de réglage de la pression ambiante et de la température ambiante est réalisée de sorte que la température ambiante prédéterminée se situe dans une plage de 200°C à 700°C.

5. Procédé selon l'une des revendications 2 ou 3, dans lequel l'étape de réglage de la pression ambiante et de la température ambiante est réalisée de sorte que la température ambiante prédéterminée se situe dans une plage de 300°C à 400°C.

6. Procédé selon l'une des revendications précédentes, dans lequel l'étape de soumission est réalisée de sorte que la durée prédéterminée se situe dans une plage de 20 minutes à 20 heures.

7. Procédé selon l'une des revendications 1 à 6, dans lequel l'étape de soumission est réalisée de sorte que la durée prédéterminée se situe dans une plage de 20 à 240 minutes.

8. Procédé selon l'une des revendications précédentes, dans lequel l'étape de préparation est réalisée de sorte que la zone d'oxyde semi-conducteur présente du dioxyde de silicium.

9. Procédé selon l'une des revendications précédentes, dans lequel le gaz inerte, un oxyde semi-conducteur de la zone d'oxyde semi-conducteur et la première et la deuxième température sont choisis de sorte que la perméabilité au gaz inerte à la première température est supérieure d'un facteur dans une plage de 500 à 50.000 qu'à la deuxième température.

10. Procédé selon l'une des revendications précédentes, dans lequel l'étape de soumission est réalisée de sorte que la pression interne prédéterminée se situe dans une plage de 0,01 Pa à 100 Pas.

11. Procédé selon l'une des revendications précédentes, dans lequel l'étape de préparation comprend la préparation d'un aménagement de plusieurs composants à semi-conducteurs sur une plaquette, et les étapes de soumission et de réglage de la température sont réalisées en commun pour tous les composants à semi-conducteurs.

12. Procédé selon l'une des revendications précédentes 1 à 10, dans lequel l'étape de préparation est réalisée de sorte qu'une pression dans la cavité (10) avant l'étape de soumission est inférieure à la pression interne prédéterminée.

13. Procédé selon l'une des revendications précédentes, dans lequel l'étape de préparation présente la disposition d'un matériau getter à l'intérieur de la cavité pour absorber, à l'activation, un gaz autre que le gaz inerte dans l'atmosphère ambiante, l'étape de soumission étant réalisé au moins de sorte que soit activé le matériau getter.

14. Procédé selon l'une des revendications précédentes, dans lequel l'étape de préparation est réalisée de sorte que le composant à semi-conducteur présente un composant micromécanique.

15. Procédé selon l'une des revendications précédentes, dans lequel l'étape de préparation est réalisée de sorte que le composant à semi-conducteur présente un microrésonateur ou un gyroscope vibratoire.

16. Procédé selon l'une des revendications précédentes, dans lequel l'étape de réglage est réalisée de sorte que la température se situe, après écoulement de la durée prédéterminée, dans une plage de -50°C à 130°C.

17. Procédé selon l'une des revendications précédentes, dans lequel l'étape de réglage est réalisée de sorte que la température se situe, après écoulement de la durée prédéterminée, dans une plage correspondant à la plage de températures d'utilisation seuil du composant à semi-conducteur.

18. Procédé selon l'une des revendications précédentes, dans lequel l'étape de réglage présente, par ailleurs, le réglage d'une pression ambiante de manière à se situer dans une plage de 0,9 bar à 1,2 bar.
